# EUROPÄISCHE PATENTSCHRIFT

(11) **EP 0 365 950 B1**
(45) Veröffentlichungstag und Bekanntmachung des Hinweises auf die Patenterteilung: **10.04.1996**
(21) Anmeldenummer: 89119109.0
(22) Anmeldetag: 14.10.1989
(51) Int. Cl.: H03K 17/972

(54) **Schaltungsanordnung zur Einstellung des Auslösepunktes in einer induktiven Tastatur**
Circuit arrangement for presetting the trigger point of a inductive keyboard
Circuit pour ajuster le point de déclenchement d'un clavier inductif

(30) Priorität: 28.10.1988 DE 3836733
(43) Veröffentlichungstag der Anmeldung: 02.05.1990
(73) Patentinhaber: Digital-Kienzle Computersysteme GmbH & Co. KG, D-78048 Villingen-Schwenningen (DE)
(72) Erfinder: Münster, Horst, D-7734 Brigachtal (DE); Wendt, Hans-Jürgen, Dipl.-Ing., D-7730 Villingen-Schwenningen (DE)
(74) Vertreter: Leiser, Gottfried, Dipl.-Ing.

(56) Entgegenhaltungen:
- EP-A- 0 009 420
- US-A- 4 494 109
- US-A- 4 529 967

## Beschreibung

Die Erfindung bezieht sich auf eine Schaltungsanordnung zur Einstellung des Auslösepunktes von kontaktlos wirksamen Tasten in einer matrixartig ausgebildeten, induktiven Tastatur, wobei jede Taste im wesentlichen aus einem Tastenknopf mit einem darin befestigten Ferritstift besteht, der bei Betätigung in übereinander auf einer Schaltungsplatte der matrixartig aufgebauten Tastatur angeordnete Wicklungen eintaucht und ein Kopplungssignal erzeugt, und die Mittel zur Beseitigung der Auswirkungen von mechanisch und elektrisch bedingten Toleranzen auf die Einstellung des Auslösepunktes aufweist.

Tastaturen der der vorbezeichneten Art sind seit einiger Zeit als Teil der Ausstattung eines Bildschirmarbeitsplatzes bekannter Baureihen in Anwendung. Die Einstellung des Auslösepunktes bei dieser bekannten Tastatur erfolgt über einen zweistufigen Abgleich. Als Stromschalter ist ein IC-Baustein (SN 7445) eingesetzt, für den eine Versorgungsspannung von 5 V ± 5 % erforderlich ist. Aufgrund von in der Zukunft zu erwartenden Beschaffungsschwierigkeiten für den IC SN 7445 und zum Zwecke einer Erweiterung der Toleranz in der Versorgungsspannung soll der IC-Baustein ersetzt werden durch sieben PNP-Transistoren. Dies hat aber zur Folge, daß die Toleranz der Kollektor-Emitter-Spannung der Stromschalter ansteigt und somit die Toleranz des Auslösepunktes erhöht wird. Mittels einer Verringerung der Spulenwindungszahl, durch die eine kostenoptimierte Leiterplattenfertigung möglich ist, werden ebenfalls die Toleranzen erhöht. Diese beabsichtigten Maßnahmen würden bei einer Tastatur in der bisherigen Technik für die Einstellung des Auslösepunktes einen mindestens 3-stufigen Abgleich für jede einzelne Tastenreihe erforderlich machen.

Toleranzen, die sich auf die Auslösepunkte in einer induktiven Tastatur auswirken, werden durch vielerlei Einflußnahmen verursacht, beispielsweise durch die Fertigungstoleranzen der eingelegten Ferritstifte in den Tastenknöpfen, durch die Fremdeinkopplungstoleranzen der Sekundärspulen, durch die Toleranz der Offsetspannung des Leseverstärkers, durch die unterschiedlichen Innenwiderstände der einzelnen Signalschalter im Multiplexer, durch Temperaturschwankungen und Versorgungsspannungstoleranzen, und durch unterschiedliche Stromflanken des Impulsgenerators wegen der unterschiedlichen Stromschalterschwellen.

Aus der europ. Patentschrift EP 0 009 420 ist eine kontaktlos induktiv wirksame Schaltereinrichtung für die Anwendung in einer matrixartig angeordneten Tastatur bekannt, die zum Erzeugen einer Schaltfunktion einen Differentialtransformator vorsieht. Jeder einzelnen Taste ist ein Differentialtransformator zugeordnet, der im wesentlichen aus zwei Paaren Primär-/Sekundärwicklungen gebildet wird, wobei jeweils die Primär- und Sekundärwicklungen in einer Ebene angeordnet und untereinander verbunden sind. Zur Veränderung der Gegeninduktivität wird ein Bauteil aus einer Position außerhalb in eine Stellung innerhalb des einen Paares aus Primär- und Sekundärwicklung bewegt, während im zweiten Wicklungspaar kein die Gegeninduktivität veränderndes Bauteil vorgesehen ist. Neben einer flächenaufwendigen Anordnung ist ein Ausgleich der Grundverkopplungssignaltoleranzen bei jeder Taste sowie der Versorgungsspannungsänderung erforderlich.

Aufgabe der Erfindung ist es, eine Schaltungsanordnung zur Einstellung des Auslösepunktes einer induktiven Tastatur und einer Funktionsüberwachung derselben anzugeben, mittels der die bekannten Schwierigkeiten bei der Einstellung des Auslösepunktes in Tastaturen der eingangs bezeichneten Art überwunden werden und ein mehrstufiger Abgleich entfallen kann.

Diese Aufgabe wird erfindungsgemäß durch die im Kennzeichen des Patentanspruches 1 angegebenen Merkmale gelöst.

Das Funktionsprinzip der Erfindung besteht darin, daß zuerst jeder der angegebenen sieben Stromschalter gesperrt wird, um einen Kondensator aufzuladen. Durch das Einschalten eines Stromschalters wird eine Tastenreihe angewählt und gleichzeitig fließt ein Stromimpuls durch die Primärreihenspulen bis der Kondensator entladen ist. Die Steilheit der Anstiegsflanke wird durch einen Mikrocomputer gesteuert, indem die Sperrzeitdauer verändert wird. Dadurch kann der Auslösepunkt einer Taste (bzw. aller Tasten) auf einen bestimmten Tastenweg eingestellt werden. In vorteilhafter Weise kann hierbei der bisher erforderliche zweistufige Abgleich entfallen, und darüberhinaus braucht die Schaltungsplatte nicht durchkontaktiert werden, da nunmehr für die Ausbildung der Primär- und Sekundärspule eine Auslegung derselben in einer geringeren Windungszahl möglich ist.

In Weiterbildung der erfindungsgemäßen Lösung werden mehrere Ausbildungsvarianten angegeben, die sich auf die Bestimmung des Wertes der Sperrzeitdauer beziehen.

Es werden hierzu Ausführungsvarianten dargestellt, bei welchen der Wert der Sperrzeitdauer beispielsweise von einem Referenzsignal abgeleitet ist. Als Referenzsignal kann das Grundverkopplungssignal der Tasten dienen. Auch kann der Wert der Sperrzeitdauer in einer möglichen zweiten Varianten als ein fester Wert einer Tabelle festgelegt sein. Der Mikrocomputer kann ohne eine zusätzliche Schaltung die Funktionsfähigkeit jeder Taste ständig überwachen (beispielsweise durch Kontrolle des Impulsgenerators, der Stromschalter und des Leseverstärkers) und bei Ausfall eine Fehlermeldung auslösen, wenn der Wert der Sperrzeit von den Grundkopplungssignalen abgeleitet wird.

Nachfolgend wird die Erfindung anhand der Zeichnungen an zwei unterschiedlichen Ausführungsbeispielen für die Einstellung des Auslösepunktes näher erläutert. Es zeigt
FIGUR 1A eine vereinfachte Darstellung der Anordnung einer Taste in einer Schaltungsplatte im Schnitt,
FIGUR 1B in schematisierter Darstellung die Anordnung einer Primär- und Sekundärspule auf der Schaltungsplatte,
FIGUR 2 schematisiert mehrere Tasten in den drei Funktionslagen in Ruhestellung, mit minimalem und mit maximalem Tastenweg zum Erreichen des Auslösepunktes,
FIGUR 3A eine Prinzipschaltung eines Impulsgenerators zur abgestuften Änderung der Steilheit der Stromimpulsflanken,
FIGUR 3B ein Impulsdiagramm zur Schaltung gemäß FIGUR 3A,
FIGUR 3C eine Schaltung eines Impulsgenerators für eine stufenlose Änderung der Steilheit der Stromimpulsflanken,
FIGUR 3D ein Impulsdiagramm zur Schaltung gemäß FIGUR 3C,
FIGUR 3E eine Schaltung eines Impulsgenerators ohne Steuerleitung zur stufenlosen Steuerung der Steilheit der Stromimpulsflanken
FIGUR 3F ein Impulsdiagramm zur Schaltung gemäß FIGUR 3E,
FIGUR 4A Prinzipschaltung eines Leseverstärkers,
FIGUREN 4B bis 4I Zustands-Impulsdiagramme im Zusammenwirken der Baugruppen Mikrocomputer, Impulsgenerator, Stromschalter, Multiplexer und Leseverstärker,
FIGUR 5 eine Prinzipschaltung einer induktiven Tastatur nach der Erfindung,
FIGUR 6 ein logisches Flußdiagramm der Verfahrensschritte gemäß der Schaltungsanordnung nach FIGUR 5,
FIGUREN 7A und 7B ein logisches Flußdiagramm bei einer Einstellung des Auslösepunktes mit Grundverkopplungssignalen.

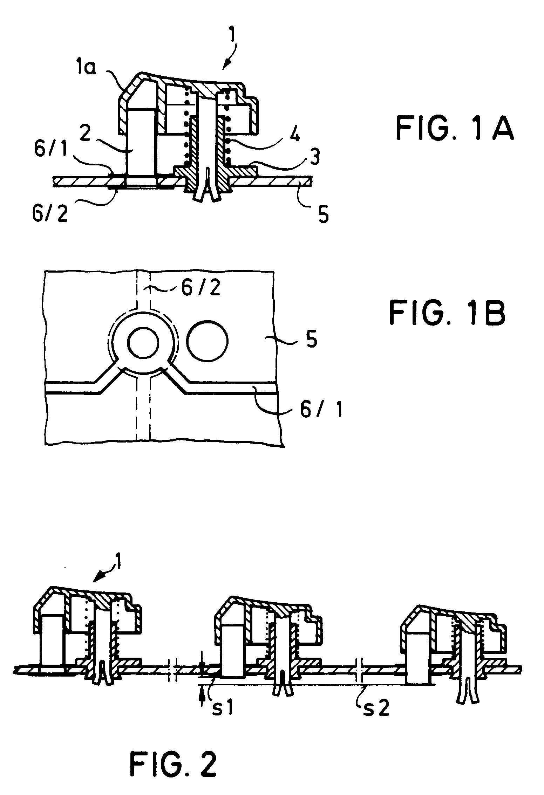

Im folgenden wird zunächst der Aufbau eines Tastenelementes gemäß FIGUR 1 beschrieben, wie es in einer Tastatur der eingangs bezeichneten Art angewandt wird. Entsprechend besteht jedes Tastenelement aus einem für dessen Betätigung erforderlichen Tastenknopf oder, einfacher ausgedrückt, aus einer Taste 1, in die ein Ferritstift 2 eingelegt ist. Die Taste 1 ist in einem Tastensockel Gehäuse 3 geführt und bildet mit letzterem eine Baueinheit. Der Tastensockel 3 ist in entsprechend ausgeführte Bohrungen auf eine Schaltungsplatte 5 aufsetzbar und wird durch Rastnasen an dem Tastensockel 3 in der Gebrauchslage in der Schaltungsplatte 5 gesichert. Eine Feder 4 stützt sich einerseits am Tastensockel 3 und andererseits an der Taste 1 ab und sorgt dafür, daß die Taste 1 nach jeder Betätigung in die Ausgangslage zurückkehrt. Bei einer Betätigung der Taste 1 taucht der an dieser befestigte Ferritstift 2 in koaxial übereinander auf der Schaltungsplatte 5 der Tastatur angeordnete Primär- (6/1) und Sekundärspulen (6/2) ein und bewirkt eine induktive Ankopplung der Primärspule 6/1 an die Sekundärspule 6/2.

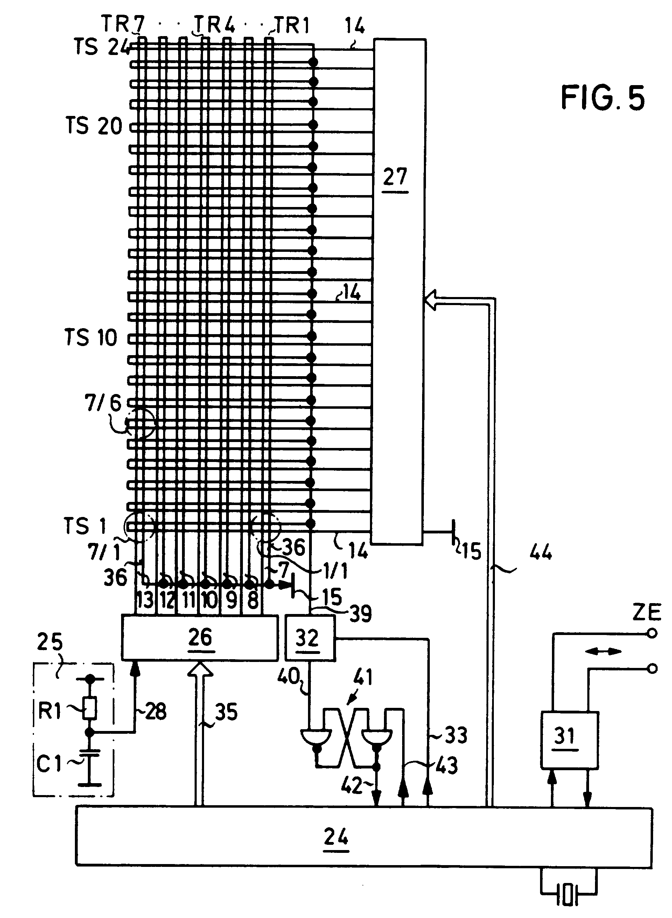

Die Tastatur gemäß dem Ausführungsbeispiel nach FIGUR 5 besteht aus einer matrixartigen Anordnung von insgesamt 168 Tasten, die im Schnittpunkt von sieben zeilenartig angelegten Tastenreihen TR1 bis TR7 mit 24 senkrecht hierzu verlaufenden Tastenspalten TS1 bis TS24 auf die Schaltungsplatte 5 aufgesetzt sind. Die Primärspulen 6/1 liegen in Leitungsschleifen 7 bis 13 und sind auf der Oberseite der Schaltungsplatte 5 (FIGUREN 1A und 1B) ) angeordnet, während die Sekundärspulen 6/2 entsprechend auf der Unterseite der Schaltungsplatte 5 vorgesehen sind und in gleichartigen Leitungsschleifen 14 entsprechend der Tastenspalten TS 1 bis TS 24 einbezogen sind. Eine schematisierte Darstellung einer Anordnung der Primär- (6/1) und Sekundärspulen (6/2) in einer Matrix ist in FIGUR 5 gezeigt, worin die Kreuzungspunkte der Leitungsschleifen 7 bis 13 mit den Leitungsschleifen 14 entsprechend der Tastenspalten TS 1 bis TS 24 jeweils die Anordnung einer Primärspule 6/1 zu einer Sekundärspule 6/2 symbolisieren. Die Leitungsschleifen 7 bis 13 für die Primärspulen 6/2 sind ausgehend von dem entsprechenden Stromschalter 26 über den Bereich der Tastenspalten TS 1 bis TS 24 zurück an die Basis 15 geführt. Die Leitungsschleifen 14 mit den Sekundärspulen 6/2 in den Tastenspalten TS 1 bis TS 24 sind ausgehend von einem Multiplexer 27, die Leitungsschleifen TR 1 bis TR 7 für die Primärspulen 6/1 überdeckend mit einem Leseverstärker 32 verbunden (siehe FIGUR 5). Beim Drücken einer Taste 1 gemäß FIGUR 1 taucht der Ferritstift 2 in die Schaltungsplatte 5 ein und bewirkt eine Ankopplung der dieser Taste 1 zugeordneten Primärspule 6/1 an die entsprechende Sekundärspule 6/2, wenn ein Stromimpuls durch die Primärspule 6/1 fließt und die Sekundärspule 6/2 der Taste 1/1 (im Beispiel Taste 1/1 in Tastenreihe TR1 und Tastenspalte TS1) angewählt ist.

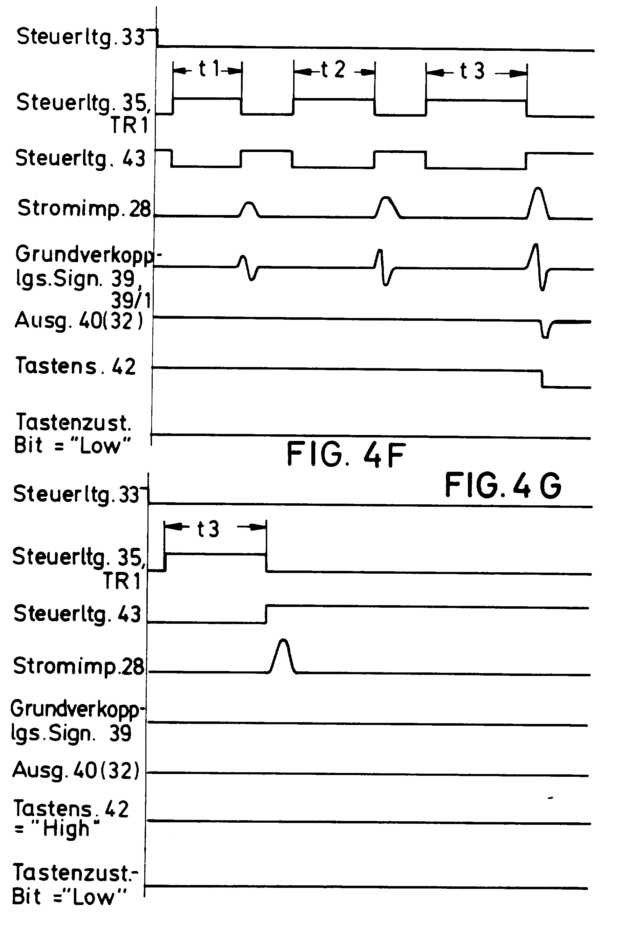

Gemäß dem Funktionsprinzip einer induktiven Tastatur wird bei jeder angewählten, aber nicht gedrückten Taste durch einen Stromimpuls 28 ein Grundverkopplungssignal 39 von der Primärspule 6/1 in die Sekundärspule 6/2 gekoppelt (FIGUR 4F). Dieses Grundverkopplungssignal 39 erhöht sich bei einer angewählten und gleichzeitig gedrückten Taste um das eigentliche Lesesignal 39/1, das durch die effektivere Kopplung der Primär (6/1)- und Sekundärspule 6/2 entsteht. Eine nicht angewählte Taste oder eine Taste mit einer Funktionsstörung liefert kein Grundverkopplungssignal 39. Eine Taste mit einem kleineren Grundverkopplungssignal 39 hat einen größeren Tastenweg s (FIGUR 2) bis zum Auslösepunkt zur Folge, wenn die Steilheit des Stromimpulses 28 nicht geändert wird. Durch diesen Umstand ist die Toleranz des Auslösepunktes bereits im nicht gedrückten Zustand einer Taste (Ruhestellung) zu erkennen.

Im Zusammenwirken (FIGUR 5) zwischen einem Mikrocomputer 24, einem Impulsgenerator 25, einem Stromschalter 26, einem Multiplexer 27 und einem Leseverstärker 32 werden die einzelnen Adressen der Tasten nacheinander angewählt und daraufhin abgefragt, ob hier eine gedrückte Taste vorliegt oder nicht. Das bedeutet, nur wenn eine Taste 1 gedrückt ist, wird ein Stromimpuls 28 des Impulsgenerators 25 von der Primärspule 6/1 auf die Sekundärspule 6/2 übertragen und wird vom Leseverstärker 32 verstärkt über eine Leitung 40 in das Flip-Flop 41 zwischengespeichert und über den Mikrocomputer 24 und Leitungen 42, 43 in den Tastenspeicher an der dieser Adresse zugeordneten Speicherposition als Tastenzustandsbit abgespeichert.

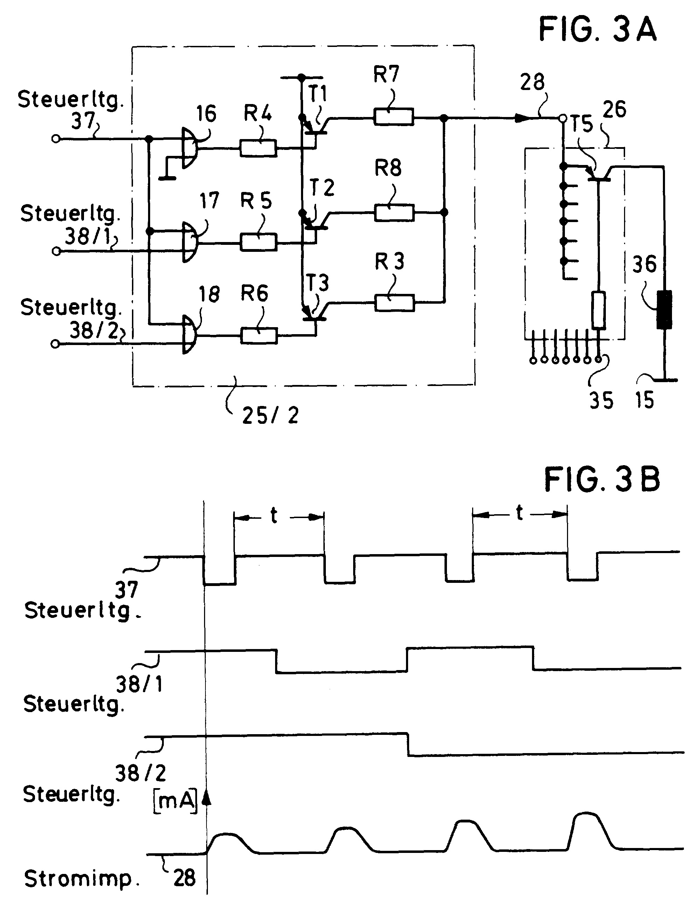

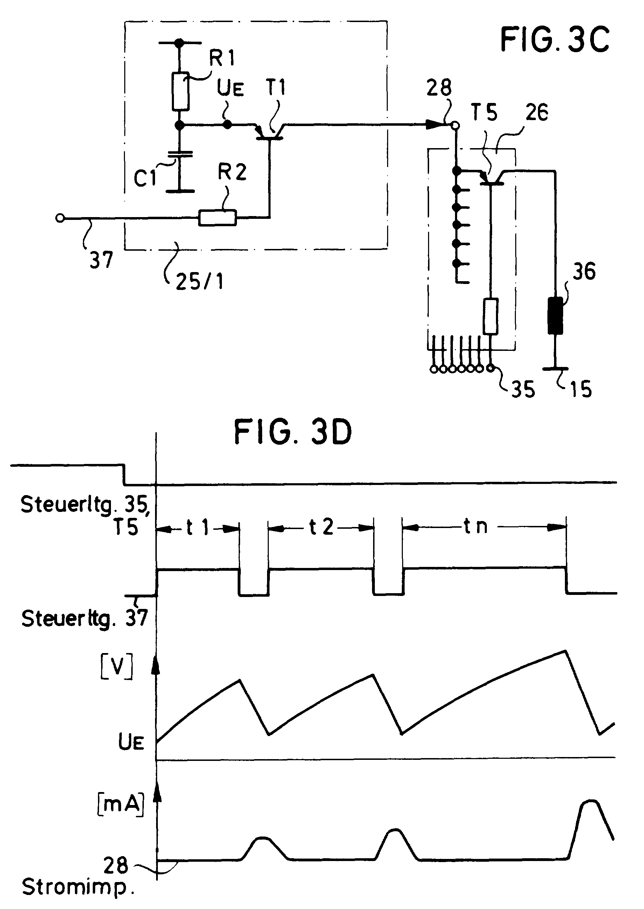

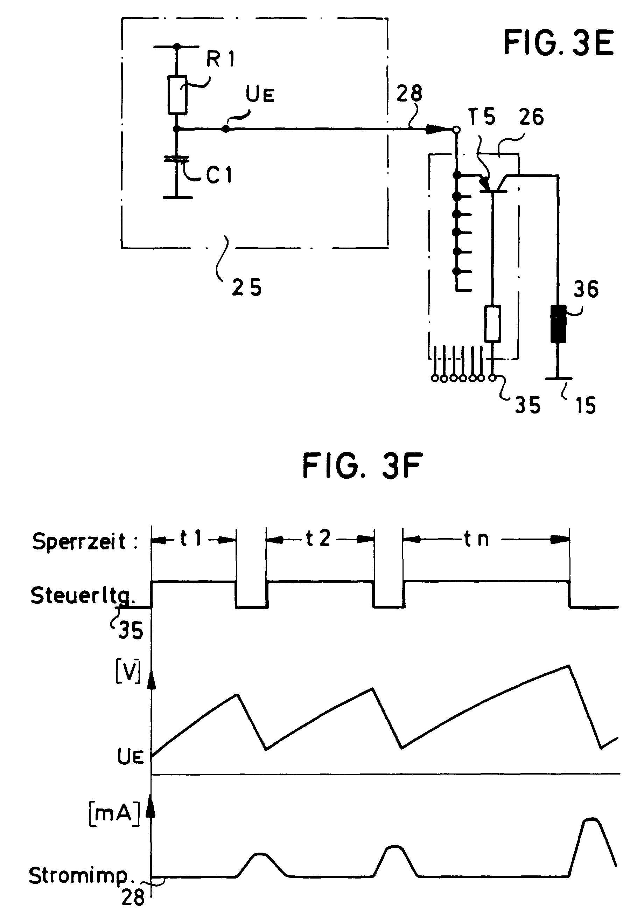

Auf die Ursachen für Toleranzen bezüglich der Lage der Auslösepunkte ist in der Beschreibungseinleitung bereits hingewiesen worden. Im einzelnen kann die Toleranz des Auslösepunktes jeder Taste beispielsweise korrigiert werden durch eine Änderung der Ferritstiftlage in der Taste 1, oder durch eine Änderung der Windungszahl der Primär- (6/1) und Sekundärspulen 6/2, oder durch die Änderung der Steilheit des Stromimpulses 28. Für eine automatische Einstellung des Auslösepunktes durch eine Programmsteuerung ist nur die Einstellung durch eine Änderung der Steilheit des Stromimpulses 28 eines Impulsgenerators 25, 25/1 oder 25/2 geeignet, der gemäß einer Schaltung nach FIGUR 3E, 3C oder 3A ausgebildet sein kann.

Eine Änderung der Steilheit der Treiber-Stromimpuls-Flanke durch einen Impulsgenerator 25/2 gemäß der Schaltung nach FIGUR 3A erfolgt in vier Stufen und wird über eine Steuerleitung 37 und zwei weiteren Steuerleitungen 38/1 und 38/2 vom Mikrocomputer 24 gesteuert. Die drei Steuerleitungen 37, 38/1, 38/2 sind jeweils über ein ODER-Glied 16, 17, 18 und einen Widerstand R4, R5 und R6 an die Basis von PNP-Transistoren T1, T2, T3 geführt, deren Emitter über Widerstände R7, R8, R3 über die gemeinsame Stromimpuls-Leitung 28 mit den Stromschaltern 26 verbunden sind. Durch Anlegen eines Low-Pegel an die Emitterseite der Transistoren T1 bis T3 werden diese leitend. Durch Zuschalten der Transistoren T2 und T3 kann so die Steilheit der Anstiegsflanke des Stromimpulses 28 erhöht werden. In FIGUR 3B ist ein schematisiertes Impulsdiagramm angezeigt, das die stufenweise Erhöhung der Steilheit der Anstiegsflanke der Stromimpulse 28 symbolisiert aufgrund der Zuschaltung der Transistoren T2 und T3 über die Steuerleitungen 38/1 ind 38/2.

Ein weiteres Ausführungsbeispiel für die Änderung der Steilheit der Anstiegsflanke des Stromimpulses 28 ist in FIGUR 3C angegeben. Ein in der dort gezeigten Schaltung angegebener Impulsgenerator 25/1 bewirkt in Abweichung zum vorgenannten Beispiel (nach FIGUR 3A) eine stufenlose Änderung der Steilheit der Anstiegsflanke des Stromimpulses 28. Der Impulsgenerator 25/1 nach FIGUR 3C verfügt nur noch über eine Steuerleitung 37, die über einen Widerstand R2 an die Basis des einzigen Transistors T1 gelegt ist. Die Emitterspannung U_{E} wird bestimmt durch einen in Reihe mit einem Widerstand R1 geschalteten Kondensator C1. Die Kollektorleitung schließlich ist zur Übertragung des Stromimpulses 28 mit den Stromschaltern 26 verbunden. Hat die Steuerleitung 37 des Impulsgenerators 25/1 einen High-Pegel erreicht, wird der Kondensator C1 über den Widerstand R1 nach einer e-Funktion aufgeladen bis die Steuerleitung 37 einen Low-Pegel annimmt (FIGUR 3D) und sich danach der Kondensator C1 über den Transistor T1 und einen Transistor T5 des Stromschalters 26 und die Primärreihenspulen 36 (bzw. 6/1) entladen kann. Die Steilheit des Stromimpulses 28 wird durch die Höhe der Spannung am Emitter von T1 bestimmt und vom Mikrocomputer 24 durch die Änderung der Sperrzeit t1 bis tn über die Steuerleitung 37 gesteuert.

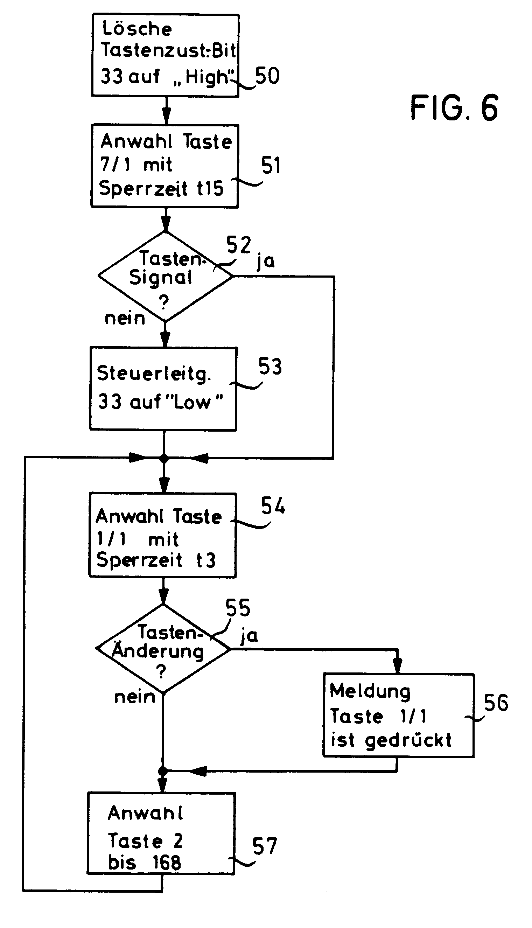

In einer weiteren bevorzugten Ausbildungsform eines Impulsgenerators 25 gemäß FIGUR 3E und FIGUR 6 entfallen gegenüber dem vordem erläuterten Impulsgenerator 25/1 die bisher erforderliche Steuerleitung 37 sowie der Transistor T1 und der Widerstand R2, was allein schon bezogen auf den Bauteileaufwand eine wesentliche Vereinfachung und Einsparung bringt. Der Impulsgenerator 25 besteht lediglich noch aus dem in Reihe mit dem Widerstand R1 geschalteten Kondensator C1, zwischen welchen eine Emitterspannung U_{E} abgegriffen und an die sieben Stromschalter 26 angelegt wird.

Die Arbeitsweise dieses Impulsgenerators 25 nach FIGUR 3E, 3F ist folgende: Zuerst werden die sieben Stromschalter 26, konkret die Transistoren T5, durch einen High-Pegel auf den sieben Steuerleitungen 35 gesperrt, um einen Kondensator C1 über den Widerstand R1 aufzuladen. Durch das Einschalten eines Stromschalters 26 mit einem Low-Pegel auf einer Steuerbzw. Portleitung 35 wird die Sperrzeit t1 bis tn beendet, und es fließt gleichzeitig ein Stromimpuls 28 durch den entsprechend angesteuerten Transistor T5 des Stromschalters 26 über die Primärspulen 6/1 der Tasten-Primärreihenspulen 36 bis der Kondensator C1 entladen ist (FIGUR 3E).

Die Steilheit des Stromimpulses 28 (siehe FIGUR 3F) wird durch den Mikrocomputer 24 gesteuert, indem dieser bei jeder einzelnen Taste die Sperrzeit t1 bis tn verändern kann.

Wird die Sperrzeit t1 geändert, z. B. verlängert in eine Sperrzeit t2, so wird die Anstiegsflanke des Stromimpulses 28 steiler, weil der Kondensator C1 auf einen höheren Spannungswert U_{E} aufgeladen ist. Dadurch nimmt die Impulshöhe des Grundverkopplungs- (39) und Lesesignals 39/1 zu, und der Tastenweg s bis zum Auslösepunkt der entsprechenden Taste verringert sich.

Für jede einzelne Taste ist ein Sperrzeitwert t1 bis tn vorgesehen, der in einer Wertetabelle steht oder aber als veränderbarer Wert in einem Schreib-/Lesespeicher hinterlegt ist.

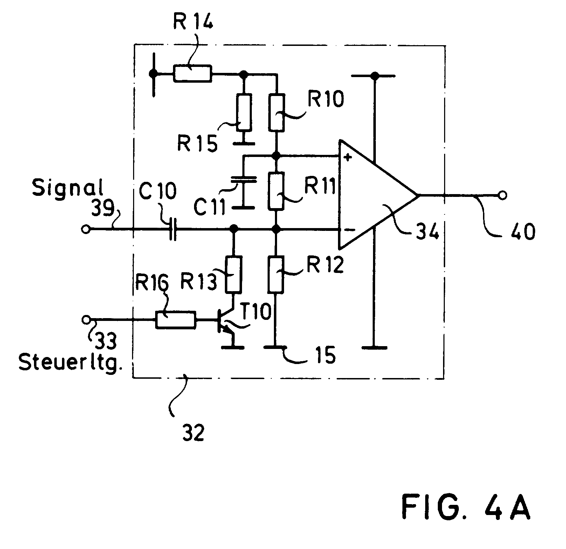

In FIGUR 4A ist ein Leseverstärker 32 angegeben, über den das Grundverkopplungssignal 39 bzw. das Lesesignal 39/1 ausgangsseitig der Sekundärspulen 6/2 (Spaltenspulen) geführt wird (FIGUR 5). Ein Signal auf der Ausgangsleitung 40 eines Spannungs-Verstärkers 34 des Leseverstärkers 32 wird in einem Flip-Flop 41 gespeichert und kann über eine Leitung 42 durch Steuerung über eine Leitung 43 vom Mikrocomputer 24 abgefragt werden. Über eine Steuerleitung 33 ist die Empfindlichkeit des Leseverstärkers 32 steuerbar. Das zugeführte Tastensignal 39, 39/1 wird durch einen Kondensator C10 im Leseverstärker 32 entkoppelt und dem Minuseingang des Verstärkers 34 zugeführt. Über einen Spannungsteiler, bestehend aus Widerständen R14 und R15 wird über Widerstände R10, R11 und R12 eine negative Vorspannung am Eingang des Verstärkers 34 angelegt. Der Pluseingang des Verstärkers 34 liegt über einen Kondensator C11 an der Basis. Die Steuerung der Empfindlichkeit erfolgt über die Steuerleitung 33, die über einen Widerstand R16 an die Basis eines Transistors T10 geführt ist. In Serie zum Widerstand R11 und parallel zum Widerstand R12 liegt im Kollektor-Emitterkreis ein Widerstand R13. Durch einen High-Pegel wird der Transistor T10 eingeschaltet und dadurch erhöht sich der Strom durch den Widerstand R11 um den Wert des Stromes, der durch R13 fließt. Dadurch erhöht sich der Spannungsabfall am Widerstand R11, und somit wird auch die negative Vorspannung am Plus-/Minuseingang des Verstärkers 34 höher und die Empfindlichkeit des Leseverstärkers 32 verringert sich.

Über das Grundverkopplungssignal 39 hinaus nimmt das Lesesignal 39/1 mit zunehmendem Tastenweg s (zwischen s1 und s2, FIGUR 2) zu und wird über den Kondensator C10 (FIGUR 4A) gleichstrommäßig entkoppelt und dem Leseverstärker 32 zugeführt. Wenn das positive Lesesignal 39/1 die negative Vorspannung am ± Eingang des Leseverstärkers 32 überwunden hat, schaltet dessen Ausgang auf der Ausgangsleitung 40 auf einen Low-Pegel. Das Flip-Flop 41 speichert den Tastenzustand (gedrückt/nicht gedrückt) ab bis das entsprechende Tastensignal auf Leitung 42 vom Mikrocomputer 24 abgefragt werden kann (FIGUR 5).

Das Grundverkopplungssignal 39 hat etwa die Hälfte der Signalhöhe eines Lesesignals 39/1. Um die Auslösepunkttoleranzen in Ruhestellung der Tasten zu ermitteln, muß daher (Einstellung durch Grundverkopplungssignale) die Empfindlichkeit des Leseverstärkers 32 von 2 mm auf 0 mm Tastenweg erhöht werden.

Durch den Spannungsteiler R14, R15 erfolgt eine Kompensation des Auslösepunktes, wenn sich die Versorgungsspannung während der Tastenabfrage ändert. Die Empfindlichkeit des Leseverstärkers 32 wird bei einer Versorgungsspannungserhöhung im gleichen Verhältnis verringert, wie der Stromimpuls 28 in der Steilheit der Anstiegsflanken über die Transistorschwelle des Transistors T5 (FIGUR 3E) zunimmt.

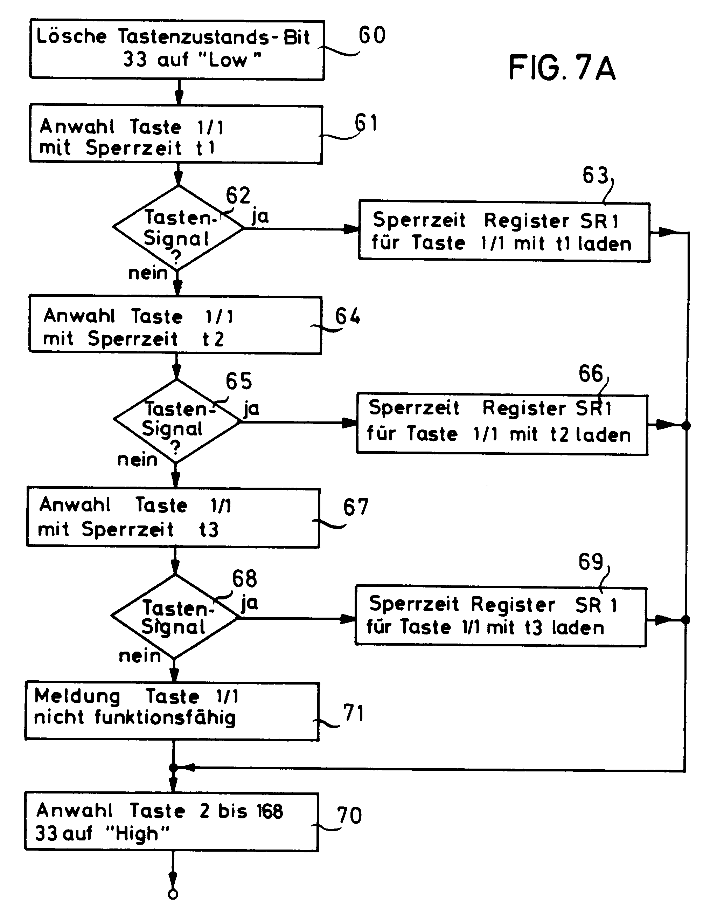

Bei der Einstellung des Auslösepunktes über einen festen Wert der Sperrzeitdauer t1 bis tn in einer Wertetabelle wird wie folgt verfahren: Jeder Taste ist ein unveränderbarer Wert von t1 bis tn zugeordnet. Entsprechend kann die Sperrzeitdauer in n-Stufen geändert werden. Die jeweiligen Werte werden für jedes neue Tastatur-Schaltungsplatten(5)-Lay-out ein einziges Mal ausgemessen. Bei jeder Taste 1 wird die Steilheit des Stromimpulses 28 durch Erhöhung der Sperrzeit der entsprechend zugeordneten Stromschalter 26 (bzw. Transistoren T5) solange erhöht, bis die Taste 1 in der Hälfte des Tastenweges auslöst. Die dabei festgestellte Sperrzeit t wird in einer Tabelle als "Programm-Maske" hinterlegt. Es entfällt dabei eine Sperrzeitermittlung, wie sie in FIGUR 7A angezeigt ist. Es ist daher auch nicht notwendig, daß jede Taste (außer der im Beispiel nach FIGUR 5 angezeigten Taste 7/1) nach dem Einschalten der Versorgungsspannung sich in der Ruhestellung befindet.

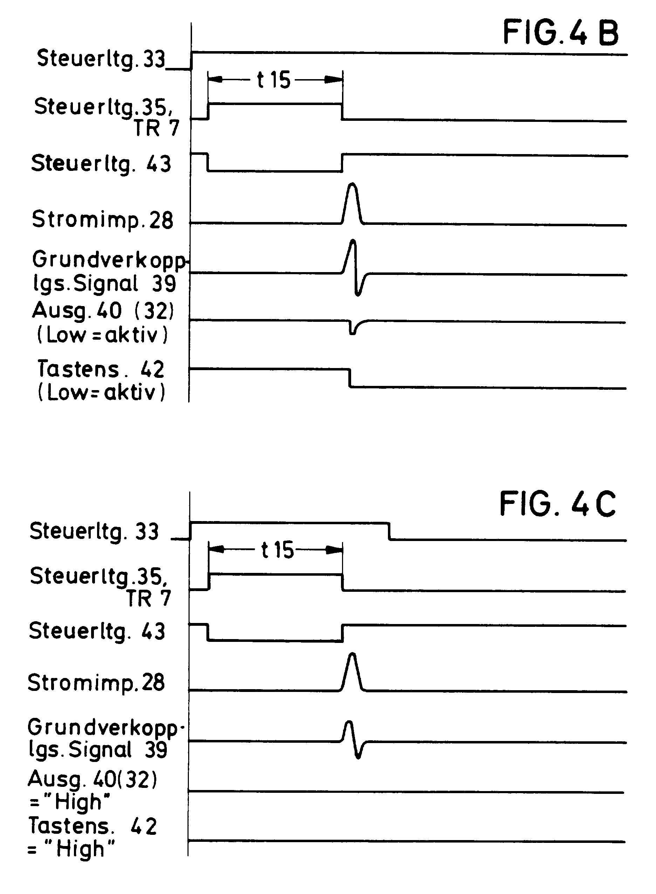

Um auch Bauteiletoleranzen, wie z. B. eine Offset-Spannung des Leseverstärkers 32 auszugleichen, wird vom Mikrocomputer 24 nach dem Einschalten der Versorgungsspannung die Taste 7/1 (gleich Taste in Tastenreihe 7 und Tastenspalte 1) angewählt (siehe hierzu FIGUR 4B, 4C, FIGUR 6, Block 51). Der Funktionsblauf im einzelnen hierzu wird nachfolgend anhand der Ausführungen zu FIGUR 6 erläutert.

Kann in Ruhestellung der Taste 7/1 kein Tastensignal auf der Leitung 42 festgestellt werden, so wird die Empfindlichkeit des Leseverstärkers 32 erhöht, indem gemäß FIGUR 4C und FIGUR 6, Block 53 die Steuerleitung 33 auf den Zustand "Low" geschaltet wird.

Das logische Flußdiagramm nach FIGUR 6 dient der Erläuterung einzelner Verfahrensschritte in der Schaltungsanordnung nach FIGUR 5, deren Ablauf sich wie folgt gestaltet:

Nach dem Einschalten der Versorgungsspannung der Tastatur gemäß FIGUR 5 wird der Block 50 (FIGUR 6) aufgerufen.

Zuerst werden die Tastenzustandsbit von Taste 1 bis 168 gelöscht (Taste in Ruhestellung = "Low") und der Leseverstärker 32 (FIGUREN 4A, 4B, 4C, 5) mit der Steuerleitung 33 ("High"-Pegel) auf empfindlich geschaltet, indem durch Zuschaltung des Transistors T10 (FIGUR 4A) die negative Vorspannung am +/- Eingang durch einen zusätzlichen Strom über den Widerstand R13 erhöht wird.

Im Anschluß erfolgt der Aufruf von Block 51. Die Taste 7/1 (in Tastenreihe TR7 und Tastenspalte TS1) wird angewählt, indem zuerst die Sekundärspulen 6/2 in der Tastenspalte TS1 durch den Multiplexer 27 über die Steuer-Leitungen 44 auf Masse geschaltet werden (FIGUR 5), damit das Lesesignal 39/1 für die Tastenspalte TS1 wirksam werden kann.

Um einen Stromimpuls 28 über die Primärspulen 6/1 in der Tastenreihe TR7 auszulösen, muß zuerste der Kondensator C1 des Impulsgenerators 25, der zu diesem Zeitpunkt vollständig entladen sein muß, über den Widerstand R1 aufgeladen werden. Nach FIGUREN 4B, 4C erfolgt dies, indem jeder der sieben Stromschalter 26 durch die Sperrzeit t15 gesperrt wird. Gleichzeitig wird mit der Steuerleitung 43 das Flip-Flop 41 (FIGUR 5) gelöscht (das Tastensignal auf Leitung 42 geht auf "High").

Der Stromimpuls 28 wird mit dem Ende der Sperrzeit t15 ausgelöst durch das Einschalten des Stromschalters 26 für die Tastenreihe TR7. Jetzt kann sich der Kondensator C1 über den entsprechenden Stromschalter 26 für die Tastentreihe TR7 und über alle Primärreihenspulen 6/1 in TR7 entsprechend Position 36 (FIGUR 3E) entladen (siehe auch FIGUREN 4B, 4C).

Der Programmablauf wird gemäß Block 52 in FIGUR 6 mit der Abfrage des Tastensignales auf der Leitung 42 fortgesetzt. Ein Tastensignal wird erkannt, wenn die Signalhöhe des Grundverkopplungssignales 39 der betreffenden Taste höher ist als die negative Vorspannung am +/- Eingang des Leseverstärkers 32. Die Folge ist dann, daß der Lesevertärker 32 am Ausgang 40 einen kurzen "Low"-Impuls liefert, der in das Flip-Flop 41 zwischengespeichert wird und das Tastensignal auf der Leitung 42 auf einen "Low"-Pegel bringt bis der Mikrocomputer 24 die Tastensignal-Leitung 42 abfragen kann.

Ist die Bedingung "Tastensignal erkannt" durch die Taste 7/1 erfüllt, so wird der Block 53 nicht aufgerufen (FIGUR 4B), weil die Steuerleitung 33 nicht verändert wird und daher direkt der Aufruf von Block 54 erfolgt.

Eine Veränderung auf der Leitung 33 von "High" auf "Low", wie im Block 53 angezeigt, bewirkt hier eine um 0,3 mm frühere Tastenauslösung für jede Taste und wird durch den Widerstandswert des Widerstandes R13 bestimmt. Über diese, vom Mikrocomputer 24 steuerbare Empfindlichkeit des Leseverstärkers 32 werden Bauteiletoleranzen, wie z. B. die Offset-Spannung des Leseverstärkers 32 kompensiert. Durch die Veränderung auf der Steuerleitung 33 wird die negative Vorspannung am +/- Eingang des Leseverstärkers 32 verringert, weil durch das Sperren des Transistors T10 der Strom durch den Widerstand R11 um den Wert reduziert wird, der zusätzlich durch den Widerstand R13 geflossen ist.

Die Einstellung des Leseverstärkers 32 erfolgt nur einmal, weil eine Wiederholung der Einstellung während der Tastenabfrage im gedrückten Zustand der Taste 7/1 zu einer fehlerhaften Einstellung des Leseverstärkers 32 führen würde.

Im Block 54 beginnt die Tastenabfrage mit der Anwahl der Taste 1/1. Zuerst werden die Sekundärspulen 6/2 für die Tastenspalte TS1 wie im Block 51 angewählt. Danach wird jeder Stromschalter 26 mit einem Sperrzeitwert t3 gesperrt, der in einer Wertetabelle im Mikrocomputer 24 hinterlegt ist. Dieser für die Taste 1/1 festgelegte Wert t3 reduziert die Tastenauslösetoleranz der Taste 1/1 umso besser, je mehr der n Stufen von t1 bis tn durch den Mikrocomputer 24 ausgewählt werden können. Die Auslösung des Stromimpulses 28 erfolgt durch das Ende der Sperrzeit t3.

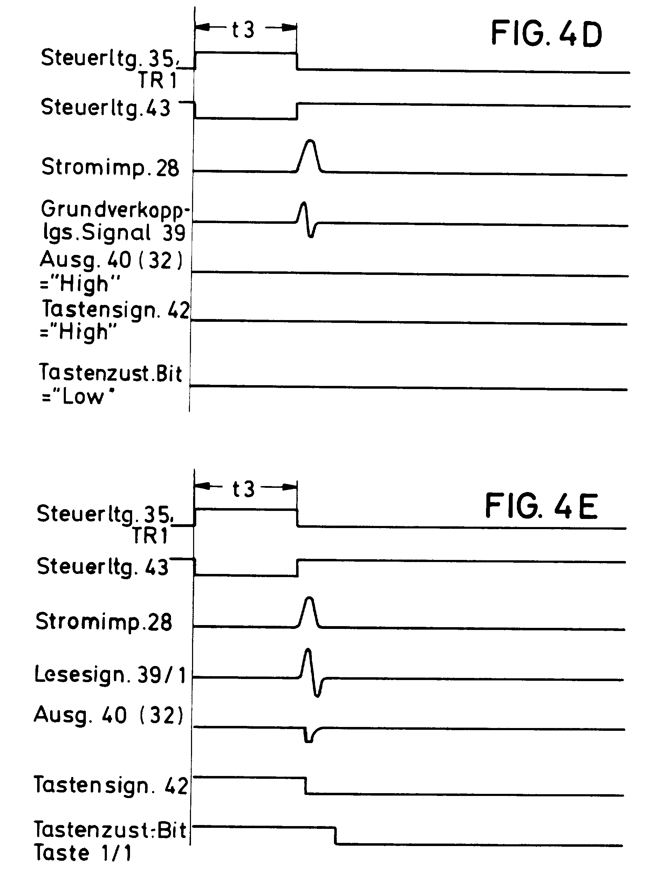

Im Block 55 erfolgt nun eine Abfrage auf die Bedingung "Tastenänderung von Taste 1/1 erkannt". Die FIGUR 4D zeigt den Funktionsablauf der Taste 1/1, bei der keine Tastenänderung festgestellt wird, weil sie in Ruhestellung ist, und es wird daher direkt der Block 57 angewählt. In FIGUR 4E wird die gedrückte Taste 1/1 angewählt und dabei eine Tastenänderung der Taste 1/1 festgestellt. In diesem Fall wird der Block 56 aufgerufen.

Eine Tastenänderung wird durch eine Exklusiv-ODER-Verknüpfung von Tastenzustandsbit und Tastensignal auf Leitung 42 festgestellt. Zur Aussage "Ja" kommt es nur, wenn das Tastenzustandsbit einen "Low"-Zustand hat und ein Tastensignal auf Leitung 42 erkannt wird (FIGUR 4E), oder wenn das Tastenzustandsbit einen "High"-Zustand hat und kein Tastensignal auf Leitung 42 erkannt wird.

Im Block 56 schließlich erfolgt eine Meldung "Taste 1/1 ist gedrückt", d. h. dieser Zustand der Taste 1/1 wird mit einem Code über eine Schnittstelle 31 an die Zentraleinheit ZE weitergegeben. Außerdem wird das Tastenzustandsbit der Taste 1/1 auf den "High"-Zustand gesetzt. Ist die Taste 1/1 bei der nächsten Anwahl gedrückt, so ist das Tastenzustandsbit der Taste 1/1 auf "High" gesetzt,und es wird gleichzeitig ein Tastensignal erkannt, und somit kann im Block 55 keine Tastenänderung festgestellt werden.

Nach Block 56 wird der Block 57 aufgerufen, indem die Tasten 2 bis 168 angewählt und entsprechend ausgewertet werden. Nach Beendigung des Blockes 57 ist ein Tastenumlauf zu Ende, und es erfolgt erneut die Anwahl von Block 54.

Die bis dahin erklärte automatische Einstellung des Auslösepunktes über die gesteuerte Steilheit des Stromimpulses 28 anhand einer einmal ermittelten Wertetabelle der Sperrzeitdauer von t1 bis tn erweist sich als eine für die praktische Anwendung am besten geeignete Einstellungsart. Sie ist als Lösung durchführbar auf der Grundlage einer stufenlosen Änderung bzw. einer automatischen, durch einen Mikrocomputer gesteuerten Änderung der Steilheit des Stromimpulses 28 aus einem entsprechend ausgebildeten Impulsgenerator 25 bzw. 25/1.

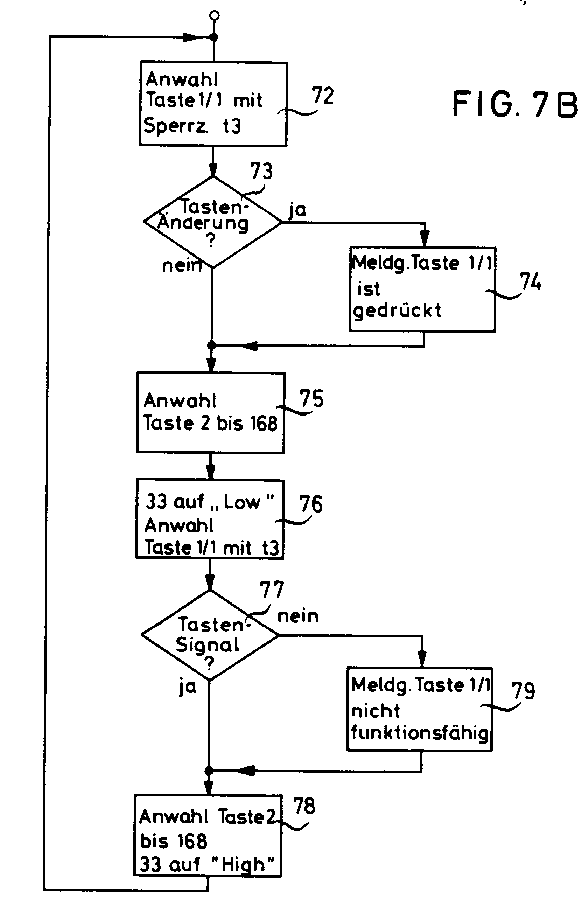

Eine weitere Möglichkeit einer Einstellung des Auslösepunktes ergibt sich aufgrund einer Anordnung, nach der der Wert der Sperrzeitdauer von den Grundverkopplungssignalen der Tasten abgeleitet wird. Der Ablauf der Einstellung des Auslösepunktes mit Grundverkopplungssignalen ist im Flußdiagramm gemäß den FIGUREN 7A und 7B angegeben. Voraussetzung während der Sperrzeitermittlung ist es, daß sich jede Taste in Ruhestellung befindet.

Nach dem Einschalten der Versorgungsspannung der Tastatur wird der Block 60 (FIGUR 7A) aufgerufen. Hierbei werden zuerst die Tastenzustandsbit im Schreib-/Lesespeicher des Mikrocomputers 24 gelöscht und der Leseverstärker 32 (siehe FIGUR 4A, 4F und 5) mit einem "Low"-Pegel auf der Steuerleitung 33 auf empfindlich eingestellt. Die Veränderung von "High" auf "Low" bewirkt hier eine um 2 mm frühere Tastenauslösung. Dadurch wird der Tastenauslösepunkt von 2 mm auf 0 mm (= Ruhestellung) verschoben, so daß jede funktionsfähige Taste ein Tastensignal liefert, weil die Höhe des Grundverkopplungssignales 39 ausreicht, um den Leseverstärker 32 am Ausgang 40 auf einen "Low"-Impuls zu schalten.

Nach Block 60 wird Block 61 aufgerufen, indem die Taste 1/1 mit der Sperrzeit t1 angewählt wird (FIGUR 4F). Der Stromimpuls 28 wird durch Beendigung der Sperrzeit t1 ausgelöst. Der Kondensator C1 kann sich jetzt über die Primärspulen 6/1 in der Tastenreihe TR1 entladen.

Der Programmablauf wird mit dem Aufruf des Blockes 62 mit der Abfrage des Tastensignales 42 fortgesetzt. Für die Taste 1/1 kann nach FIGUR 4F kein Tastensignal festgestellt werden, und somit erfolgt der Aufruf von Block 64.

Ist dagegen die Bedingung "Tastensignal erkannt" erfüllt, so erfolgt der Aufruf von Block 63.

In Block 63 wird für die Taste 1/1 in ein Sperrzeit-Register SR 1 der Wert "1" abgespeichert. Danach erfolgt der Aufruf von Block 70.

Wurde für die Taste 1/1 für die Sperrzeit t1 gemäß Block 62 kein Tastensignal erkannt, dann wird gemäß Block 64 bei der nächsten Anwahl der Taste 1/1 die Sperrzeit auf den Wert t2 erhöht mit dem Ziel, die Anstiegsflanke des Stromimpulses 28 zu erhöhen. Die Taste 1/1 wird deshalb erneut angewählt, weil bei dieser Taste bislang kein Tastensignal auf Leitung 42 erkannt wurde.

Im darauf folgenden Block 65 erfolgt erneut die Abfrage bezüglich eines Tastensignales auf Leitung 42 der Taste 1/1. Die Bedingung ist auch für die Sperrzeit t2 nicht erfüllt (siehe FIGUR 4F), und es erfolgt daher der Aufruf des Blockes 67.

Für den Block 66 gilt sinngemäß das gleiche wie für den Block 63 mit dem Unterschied, daß wenn für die Taste 1/1 ein Tastensignal erkannt wurde, hier der Wert "2" ins Sperrzeit-Register SR1 geladen wird.

Im Block 67 wird nunmehr die Sperrzeit t2 auf den Wert t3 erhöht, siehe auch hierzu FIGUR 4F, und die Taste 1/1 wird erneut angewählt, da bis dahin noch kein Tastensignal auf Leitung 42 festgestellt wurde.

Nach Block 67 folgt Block 68 mit der erneuten Abfrage des Tastensignales auf Leitung 42. Nun ist die Bedingung "Tastensignal erkannt" nach FIGUR 4F erfüllt, weil jetzt das nochmals erhöhte Grundverkopplungssignal 39 der Taste 1/1 den Ausgang 40 des Leseverstärkers 32 auf einen "Low"-Impuls schalten kann.

Hat dagegen die Taste 1/1 eine Funktionsstörung, so erfolgt nachfolgend auf den Block 68 der Aufruf von Block 71.

Da im Block 68 für die Taste 1/1 ein Tastensignal erkannt wurde, wird im Sperrzeit-Register SR1 der Wert "3" abgespeichert. Um die Auslösetoleranz der Taste 1/1 zu reduzieren, ist die maximale Sperrzeit t3 notwendig. Die spätere Anwahl der Taste 1/1 erfolgt stets mit dem im Sperrzeit-Register SR1 abgespeicherten Sperrzeitwert t3.

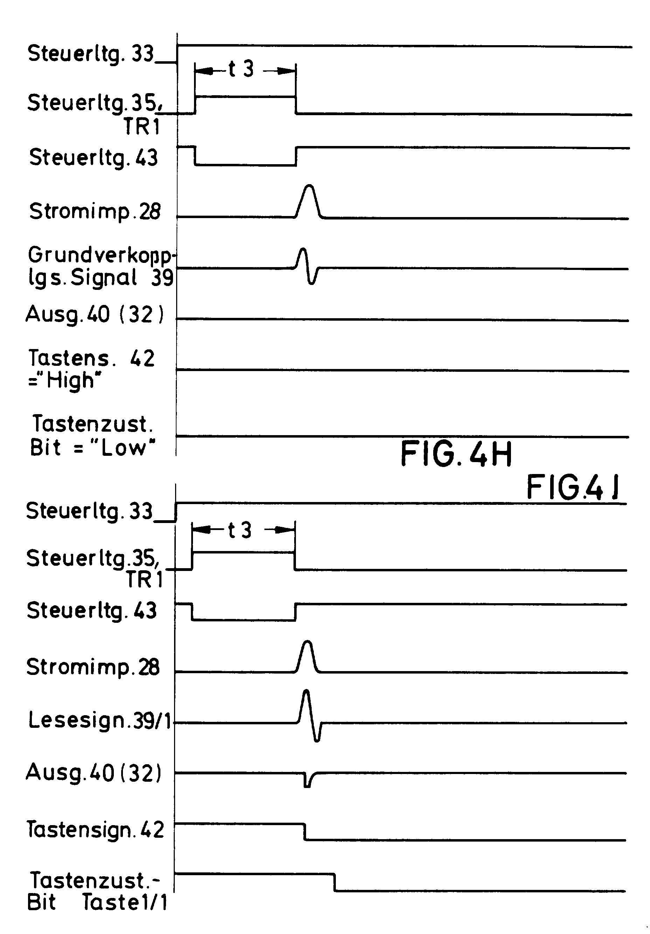

Nachfolgend auf den Block 69 oder 71 wird der Block 70 aufgerufen. Nachdem der Sperrzeitwert für die Taste 1/1 ermittelt wurde, werden nun die Werte der Sperrzeiten der Tasten 2 bis 168 ermittelt und im Sperrzeit-Register SR2 bis SR168 entsprechend abgespeichert (siehe FIGUREN 4H, 4I). Anschließend wird die Empfindlichkeit des Leseverstärkers 32 durch einen "High"-Pegel über Steuerleitung 33 verringert, damit ein Tastensignal nur im gedrückten Zustand der Tasten erkannt werden kann.

Für den Block 71 ist noch ergänzend zu bemerken: Hat die Taste 1/1 eine Funktionsstörung, so kann kein Tastensignal auf Leitung 42 festgestellt werden. Von der Tastatur erfolgt dann eine Fehlermeldung "Taste 1/1 nicht funktionsfähig" an die Zentraleinheit ZE.

In der Fortsetzung des Flußdiagrammes gemäß FIGUR 7B erfolgt die Anwahl der Tasten mit den zuvor abgespeicherten Werten im Sperrzeit-Register SR1 bis SR168. Den Funktionsablauf der Tastenanwahl der Taste 1/1 zeigt die FIGUR 4D, wenn sich die Taste 1/1 in Ruhestellung befindet, oder die FIGUR 4E, wenn die Taste 1/1 gedrückt ist.

Nachfolgend auf den Block 70 erfolgt der Aufruf von Block 72. Die Anwahl der Taste 1/1 geschieht mit dem Sperrzeitwert t3 aus dem Sperrzeit-Register SR1 (siehe FIGUREN 4H, 4I).

Nach Block 72 erfolgt im Block 73 eine Abfrage mit der Bedingung "Tastenänderung von Taste 1/1 erkannt". Befindet sich nun die Taste 1/1 in Ruhestellung, wird Block 75 aufgerufen (FIGUR 4H). Ist dagegen die Bedingung "Tastenänderung erkannt" erfüllt, so stellt sich der Ablauf gemäß FIGUR 4I dar, und der Block 74 wird aufgerufen.

Die Funktionsablaufschritte für den Block 74 sind die gleichen wie sie bereits für den Block 56 dargestellt und erläutert wurden.

Ausgehend vom Block 74 oder vom Block 73 wird nun der Block 75 aufgerufen. In diesem Teil des Flußdiagrammes werden die Tasten 2 bis 168 angewählt und ausgewertet (siehe FIGUR 4H, 4I).

Auf den Block 75 folgt der Block 76. Hier wird die Taste 1/1 auf Funktionsfähigkeit überprüft (siehe FIGUR 4G). Durch einen "Low"-Pegel der Steuerleitung 33 wird die Empfindlichkeit des Leseverstärkers 32 erhöht, so daß im nicht gedrückten Zustand der Taste 1/1 ein Tastensignal auf Leitung 43 erkannt werden kann, wenn die Taste 1/1 funktionsfähig ist.

Entsprechend folgt nachfolgend auf den Block 76 die Abfrage gemäß Block 77 mit der Bedingung "Tastensignal erkannt?". Die FIGUR 4G zeigt den Funktionsablauf, wenn die Taste 1/1 eine Funktionsstöhrung hat und somit Block 79 aufgerufen wird. Ist andererseits die Bedingung "Tastensignal erkannt?" erfüllt, so erfolgt der Aufruf von Block 78.

In diesem Programmteil gemäß Block 78 werden die Tasten 2 bis 168 auf eine Funktionsstörung untersucht (siehe FIGUR 4G). Im Fehlerfall erfolgt wie im Block 79 eine Fehlermeldung an die Zentraleinheit ZE. Bevor der Aufruf von Block 72 erfolgen kann, muß die Steuerleitung 33 auf einen "High"-Pegel gesetzt werden, d. h. der Leseverstärker 32 muß auf unempfindlich geschaltet werden.

Für den Block 79 bleibt nachzutragen, daß wenn die Taste 1/1 eine Funktionsstörung hat, als Resultat hieraus die Meldung "Taste 1/1 nicht funktionsfähig" an die Zentraleinheit ZE erfolgt.

Die Einstellungsart des Auslösepunktes der Tasten mittels Grundverkopplungssignal kann nur in vier Schritten erfolgen, wenn nur zwei Bit für den Wert der Sperrzeitdauer zur Verfügung stehen. Es muß damit in der Praxis eine Auslösetoleranz von 3 mm ausgeglichen werden. Hinzu kommt noch eine Toleranz aufgrund einer Fehleinstellung der Tasten, weil die Einstellung der Tasten in Ruhestellung und nicht in gedrücktem Zustand (2 mm) erfolgt. Dies führt zu Schwierigkeiten bei der Einhaltung von zu engen Toleranzen für die Lage des Auslösepunktes. Durch eine Vergrößerung des internen Speichers in dem Mikrocomputer bzw. durch die Bereitstellung von mehr Bit für den Wert der Sperrzeitdauer erweist sich die Einstellungsart des Auslösepunktes mittels Grundverkopplungssignal als eine praktikable Lösung.

Am besten geeignet für eine problemlose Einstellung des Auslösepunktes ist die Einstellung mittels einer Wertetabelle. Es ist auch denkbar, mehrere verschiedene Wertetabellen zu hinterlegen, um dadurch beispielsweise eine durch eine generelle Veränderung in der Tastatur bedingte Verschiebung der Auslösepunkte zu erfassen.

Mit der Einrichtung gemäß FIGUR 5 ist es auch möglich, einen Funktionstest ohne Tastenelemente durchzuführen. Um die Prüfung der Tastatur-Schaltungsplatte 5 zu vereinfachen, wird beim Funktionstest zum Widerstand R11 in FIGUR 4A ein Widerstand geschaltet. Dadurch wird der Leseverstärker 32 sehr empfindlich, und schon allein das Grundverkopplungssignal 39 löst bei jeder funktionsfähigen Spule 6/1, 6/2 eine Tastenmeldung über die Schnittstelle 31 aus (FIGUR 5).

## Patentansprüche

1. Schaltungsanordnung zur Einstellung des Auslösepunktes von kontaktlos wirkenden Tasten in einer matrixartig ausgebildeten induktiven Tastatur, wobei jede Taste (1) im wesentlichen aus einem Tastenkopf (1a) mit einem darin befestigten Ferritstift (2) besteht, der bei einer Tastenbetätigung in übereinanderliegende, auf einer Schaltungsplatte (5) der Tastatur angeordnete Primär- und Sekundärspulen (6/1, 6/2) eintaucht und ein Kopplungssignal erzeugt, dadurch gekennzeichnet, daß sie einen Impulsgenerator (25) und einen von einem Mikrocomputer (24) gesteuerten Stromschalter (26) enthält, über den der Impulsgenerator (25) mit der einer ausgewählten Taste (1) zugeordneten Primärspule (6/1) verbindbar ist, daß der Mikrocomputer (24) über Steuerleitungen (37, 38/1, 38/2, 35) mit dem Impulsgenerator (25) und/oder dem Stromschalter (26) verbunden ist, um die Flankensteilheit des der Primärspule (6/1) zugeführten Stromimpulses automatisch entsprechend einem vorgebbaren, den Auslösepunkt der Taste (1) bestimmenden Wert zu steuern, und daß die der ausgewählten Taste (1) zugeordnete Sekundärspule (6/2) über einen Leseverstärker (32) mit einem Flip-Flop (41) verbunden ist, um dem Mikrocomputer (24) ein für den jeweiligen Tastenzustand repräsentatives Signal zu liefern.

2. Schaltungsanordnung nach Anspruch 1,
dadurch gekennzeichnet,
daß der für die Erzeugung des Stromimpulses (28) vorgesehene Impulsgenerator (25, 25/1, 25/2) bei einer Anordnung von sieben Tastenreihen (TR1 bis TR7) über entsprechend sieben Stromschalter (26) und durch vom Mikrocomputer (24) wahlweise aktivierbaren Steuerleitungen (35) mit den Primärspulen (6/1) der Tastenreihen (TR1 bis TR7) verbindbar ist.

3. Schaltungsanordnung nach Anspruch 2,
dadurch gekennzeichnet,
daß die sieben Stromschalter (26) durch eine Anordnung von sieben PNP-Transistoren ausgebildet sind.

4. Schaltungsanordnung nach Anspruch 1,
dadurch gekennzeichnet,
daß eine Änderung der Steilheit der Anstiegsflanke des Stromimpulses (28) durch den Mikrocomputer (24) gesteuert wird über eine variabel einstellbare Veränderung einer Sperrzeitdauer (t1 bis tn) für die Stromschalter (26).

5. Schaltungsanordnung nach Anspruch 4,
dadurch gekennzeichnet,
daß zuerst jeder der sieben Stromschalter (26) für eine bestimmte Sperrzeitdauer gesperrt ist, um einen Kondensator (C1) aufzuladen, und
daß durch das Einschalten eines Stromschalters (26) eine Tastenreihe (TR1 bis TR7) angewählt wird und gleichzeitig ein Stromimpuls (28) durch die Primärspulen (6/1) der angewählten Tastenreihe (TR1 bis TR7) fließt, bis der Kondensator (C1) entladen ist.

6. Schaltungsanordnung nach Anspruch 5,
dadurch gekennzeichnet,
daß die Schaltung der Sperrzeitdauer (t1 bis tn) der Stromschalter (26), sowie die Einschaltung eines Stromschalters (26) für die Aktivierung einer Tastenreihe (TR) über Steuerleitungen (35) vom Mikrocomputer (24) aus erfolgt.

7. Schaltungsanordnung nach Anspruch 2,
dadurch gekennzeichnet,
daß ein Impulsgeber (25/2) vorgesehen ist für eine stufenweise Änderung der Steilheit des Stromimpulses (28), indem dieser (25/2) eine Steuerleitung (37) mit einem Transistor (T1) und zwei weitere zuschaltbare Steuerleitungen (38/1 und 38/2) mit Stromschalt-Transistoren (T2 und T3) aufweist, dergestalt daß mit einem "Low"-Pegel über die Steuerleitungen (37, 38/1, 38/2) die Transistoren (T1, T2, T3) leitend werden und somit die Steilheit des Stromimpulses (28) stufenweise erhöht wird.

8. Schaltungsanordnung nach Anspruch 2,
dadurch gekennzeichnet,
daß für eine stufenlose Änderung der Steilheit des Stromimpulses (28) ein Impulsgeber (25/1) vorgesehen ist, bestehend aus einem RC-Glied für den Aufbau einer Emitterspannung (U_{E}), eines Transistors (T1), wobei der Kondensator (C1) nach einer e-Funktion aufgeladen wird, solange auf einer Steuerleitung (37) ein "High"-Pegel an der Basis eines Transistors (T1) anliegt, und wobei sich der Kondensator (C1) über die Primärspulen (6/1) entladen kann, wenn die Steuerleitung (37) einen "Low"-Pegel annimmt, wobei die Steilheit des Stromimpulses (28) durch die Höhe der Spannung (U_{E}) am Emitter bestimmt und durch die vom Mikrocomputer (24) einstellbare Änderung der Sperrzeit (t1 bis tn) auf der Steuerleitung 37 steuerbar ist.

9. Schaltungsanordnung nach Anspruch 2,
dadurch gekennzeichnet,
daß für eine automatische Einstellung des Auslösepunktes ein Impulsgenerator (25) vorgesehen ist, der aus einem Widerstand (R1) und einem Kondensator (C1) besteht und mit sieben Stromschaltern (26) verbunden ist, dergestalt daß über einen "High"-Pegel auf den sieben Steuerleitungen (35) die sieben Stromschalter (26) gesperrt sind, um den Kondensator (C1) über den Widerstand (R1) aufzuladen, daß mit einem "Low"-Pegel auf einer Steuerleitung (35) ein Stromschalter (26) leitend wird und die Sperrzeit (t1 bis tn) beendet ist und ein Stromimpuls (28) über einen Transistor (T5) fließt bis der Kondensator (C1) entladen ist.

10. Schaltungsanordnung nach Anspruch 9,
dadurch gekennzeichnet,
daß die Steilheit eines jeden Stromimpulses (28) durch einen Mikrocomputer (24) variabel steuerbar ist, indem durch letzteren (24) der Sperrzeitwert (t1 bis tn) bei jeder einzelnen Taste (1) veränderbar ist, und somit jeder einzelnen Taste ein Sperrzeitwert (t1 bis tn) zuordenbar ist.

11. Schaltungsanordnung nach Anspruch 10,
dadurch gekennzeichnet,
daß für jede einzelne Taste (1) eine einmal ermittelte und zugeordnete Sperrzeit (t1 bis tn) als unveränderbarer Wert in einer Wertetabelle hinterlegt ist.

12. Schaltungsanordnung nach Anspruch 10,
dadurch gekennzeichnet,
daß für jede einzelne Taste (1) ein Sperrzeitwert vorgesehen ist, der als veränderbarer Wert in einem Schreib-Lese-Speicher des Mikrocomputers (24) hinterlegt ist.

13. Schaltungsanordnung nach Anspruch 1,
dadurch gekennzeichnet,
daß ein Leseverstärker (32) vorgesehen ist, dessen Emmpfindlichkeit über eine Steuerleitung (33) vom Mikrocomputer (24) steuerbar ist, derart daß eine Veränderung der Zustände von "High" auf "Low" auf der Steuerleitung (33) eine um 2 mm variierbare, frühere Auslösung eines Tastensignals am Ausgang (40) bewirkt, dergestalt daß eine funktionsfähige Taste (1) ein Tastensignal liefert, da die Höhe eines Grundverkopplungssignals (39) ausreicht, den Leseverstärker (32) am Ausgang (40) auf einen "Low"-Impuls zu schalten.

14. Schaltungsanordnung nach Anspruch 1,
dadurch gekennzeichnet,
daß ausgangsseitig des Leseverstärkers (32) das Flip-Flop (41) vorgesehen ist, um ein vorliegendes Tastensignal zu speichern bis eine Abfrage eines Tastensignals über Leitungen (42, 43) durch den Mikrocomputer (24) erfolgt.

## Claims

1. A circuit arrangement for presetting the trigger point of keys acting without contact in an inductive keyboard designed like a matrix, wherein each key (1) essentially consists of a key head (1a) having a ferrite peg (2) attached therein, which, when a key is operated, dips into primary and secondary coils (6/1, 6/2) lying one on top of the other and disposed on a card (5) of the keyboard and produces a coupling signal,
**characterised in that** it contains a pulse generator (25) and a switch (26) controlled by a microcomputer (24), via which the pulse generator (25) can be connected to the primary coil (6/1) assigned to a selected key (1),
**in that** the microcomputer (24) is connected via control lines (37, 38/1, 38/2, 35) to the pulse generator (25) and/or the switch (26) in order to control automatically the rate of rise of the edge of the current pulse supplied to the primary coil (6/1) corresponding to a presettable value determining the trigger point of the key (1),
**and in that** the secondary coil (6/2) assigned to the selected key (1) is connected via a read amplifier (32) to a flip-flop (41) in order to supply a signal representative of the respective key status to the microcomputer (24).

2. A circuit arrangement according to Claim 1,
**characterised in that**, in an arrangement of seven rows of keys (TR1 to TR7), the pulse generator (25, 25/1, 25/2) provided for the generation of the current pulse (28) can be connected to the primary coils (6/1) of the rows of keys (TR1 to TR7) via correspondingly seven switches (26) and by control lines (35) which can be selectively activated by the microcomputer (24).

3. A circuit arrangement according to Claim 2,
**characterised in that** the seven switches (26) are constructed by an arrangement of seven PNP transistors.

4. A circuit arrangement according to Claim 1,
**characterised in that** a change in the rate of rise of the rising edge of the current pulse (28) is controlled by the microcomputer (24) via a variably adjustable change of an idle time period (t1 to tn) for the switches (26).

5. A circuit arrangement according to Claim 4,
**characterised in that** at first each of the seven switches (26) is inhibited for a determined idle time period in order to charge a capacitor (C1),
and in that by the connection of a switch (26) a row of keys (TR1 to TR7) is selected and at the same time a current pulse (28) flows through the primary coils (6/1) of the selected row of keys (TR1 to TR7) until the capacitor (C1) is discharged.

6. A circuit arrangement according to Claim 5,
**characterised in that** the switching of the idle time period (t1 to tn) of the switches (26), and also the connection of a switch (26) for the activation of a row of keys (TR) is performed via control lines (35) from the microcomputer (24).

7. A circuit arrangement according to Claim 2,
**characterised in that** a pulse generator (25/2) is provided for a step-by-step change in the rate of rise of the current pulse (28), by said pulse generator (25/2) having a control line (37) with a transistor (T1) and two further connectable control lines (38/1 and 38/2) with switching transistors (T2 and T3) so that with a low level via control lines (37, 38/1, 38/2) the transistors (T1, T2, T3) become inductive and consequently the rate of rise of the current pulse (28) is increased step-by-step.

8. A circuit arrangement according to Claim 2,
**characterised in that** for a step-by-step change in the rate of rise of the current pulse (28) a pulse generator (25/1) is provided, consisting of an RC module for the build-up of an emitter voltage (U_{E}), of a transistor (T1), whereby the capacitor (C1) is charged after an e function as long as on a control line (37) a high level is present at the base of a transistor (T1), and whereby the capacitor (C1) can by discharged via the primary coils (6/1) if the control line (37) assumes a low level, whereby the rate of rise of the current pulse (38) is determined by the level of the voltage (U_{E}) at the emitter and can be controlled by the change in the idle time (t1 to tn), which can be adjusted by the microcomputer (24), on the control line 37.

9. A circuit arrangement according to Claim 2,
**characterised in that** for an automatic presetting of the trigger point a pulse generator (25) is provided, which consists of a resistor (R1) and a capacitor (C1) and is connected to seven switches (26), so that the seven switches (26) are inhibited via a high level on the seven control lines (35) in order to charge the capacitor (C1) via the resistor (R1),
in that with a low level on a control line (35) a switch (26) becomes conductive and the idle time (t1 to tn) is ended an a current pulse (28) flows via a transistor (T5) until the capacitor (C1) is discharged.

10. A circuit arrangement according to Claim 9,
**characterised in that** the rate of rise of each current pulse (28) can be variably controlled by a microcomputer (24), by the idle time value (t1 to tn) being altered by the latter (24) for each individual key (1), and consequently an idle time value (t1 to tn) can be assigned to each individual key.

11. A circuit arrangement according to Claim 10,
**characterised in that** for each individual key (1) a once determined and assigned idle time (t1 to tn) is deposited as a constant value in a truth table.

12. A circuit arrangement according to Claim 10,
**characterised in that** an idle time value, which is deposited as a changeable value in a read-write memory of the microcomputer (24), is provided for each individual key (1).

13. A circuit arrangement according to Claim 1,
**characterised in that** a read amplifier (32) is provided, the sensitivity of which can be controlled via a control line (33) from the microcomputer (24) in such a manner that a change in the statuses from high to low on the control line (33) brings about an earlier triggering, variable by 2 mm, of a key signal at the output (40) so that an operative key (1) supplies a key signal, as the level of a basic coupling signal (39) is sufficient to switch the read amplifier (32) at the output (40) to a low pulse.

14. A circuit arrangement according to Claim 1,
**characterised in that** the flip-flop (41) is provided on the output side of the read amplifier (32) in order to store an available key signal until an interrogation of a key signal via lines (42, 43) is performed by the microcomputer (24).

## Revendications

1. Dispositif de commande pour le réglage du point de déclenchement de touches agissant sans contact, sur un clavier inductif de type matriciel, chaque touche (1) étant composée essentiellement d'une tête de touche (1a) à laquelle est fixée une cheville en ferrite (2) qui, lorsque l'on actionne une touche, descend dans des bobines primaire et secondaire (6/1, 6/2) superposées et disposées sur une plaquette à circuits imprimés (5) du clavier, et produit un signal de couplage, caractérisé en ce qu'il comporte un générateur d'impulsions (25), et un commutateur de courant (26) commandé par un micro-ordinateur (24), et par l'intermédiaire duquel le générateur d'impulsions (25) peut être connecté à la bobine primaire (6/1) associée à une touche (1) sélectionnée, en ce que le micro-ordinateur (24) est connecté au générateur d'impulsions (25) et/ou au commutateur de courant (26) par l'intermédiaire de lignes de commande (37, 38/1, 38/2, 35), pour commander automatiquement la raideur de pente du signal de l'impulsion de commande amenée à la bobine primaire (6/1), en fonction d'une valeur présélectionnable déterminant le point de déclenchement de la touche (1), et en ce que la bobine secondaire (6/2) associée à la touche sélectionnée (1) est connectée à un flip-flop (41) par l'intermédiaire d'un amplificateur de lecture (32), pour fournir au micro-ordinateur (24) un signal représentatif de chacun des états de la touche.

2. Dispositif de commande selon la revendication 1, caractérisé en ce que le générateur d'impulsions (25, 25/1, 25/2)) prévu pour la production d'une impulsion de courant (28) peut être connecté, pour une disposition à sept rangées de touches (TR1 à TR7), aux bobines primaires (6/1) des rangées de touches (TR1 à TR7) par l'intermédiaire de sept commutateurs de courant (26) correspondants, et par des lignes de commande (35) pouvant être activées au choix par le micro-ordinateur (24).

3. Dispositif de commande selon la revendication 2, caractérisé en ce que les sept commutateurs de courant (26) sont constitués selon une disposition à sept transistors PNP.

4. Dispositif de commande selon la revendication 1, caractérisé en ce qu'une modification de la raideur de pente du flanc intérieur de l'impulsion de courant (28) est commandée par le micro-ordinateur (24) par l'intermédiaire d'une modification variable réglable d'une durée du temps inactif (t1 à tn) pour le commutateur de courant (26).

5. Dispositif de commande selon la revendication 4, caractérisé en ce que chacun des sept commutateurs de courant (26) est d'abord inactif pour une durée déterminée du temps inactif, pour charger un condensateur (C1), et en ce qu'une rangée de touches (TR1 à TR7) est sélectionnée par la mise en circuit d'un commutateur de courant (26) en même temps qu'une impulsion de courant (28) passe par les bobines primaires (6/1) de la rangée de touches sélectionnée (TR1 à TR7), jusqu'à ce que le condensateur (C1) soit chargé.

6. Dispositif de commande selon la revendication 5, caractérisé en ce que la commande de la durée du temps inactif (t1 à tn) du commutateur de courant (26), ainsi que la mise en circuit d'un commutateur de courant (26) pour l'activation d'une rangée de touches (TR) sont assurées par l'intermédiaire de lignes de commande (35) du micro-ordinateur (24).

7. Dispositif de commande selon la revendication 2, caractérisé en ce qu'un émetteur d'impulsions (25/2) est prévu pour une modification graduelle de la raideur de pente de l'impulsion de courant (28), celui-ci (25/2) présentant une ligne de commande (37) comportant un transistor (T1), et deux autres lignes de commande (38/1 et 38/2) pouvant être mises en circuit et comportant deux transistors de commutation (T2 et T3), de telle sorte que, à un niveau bas , les transistors (T1, T2, T3) passent en connexion par l'intermédiaire des lignes de commande (37, 38/1, 38/2), et la raideur de pente de l'impulsion de courant (28) peut ainsi être augmentée graduellement.

8. Dispositif de commande selon la revendication 2, caractérisé en ce qu'un émetteur d'impulsion (25/1) est prévu pour une modification graduelle de la raideur de pente de l'impulsion de courant (28), lequel émetteur est composé d'un circuit RC pour la formation d'une tension émetteur (U_{E}), d'un transistor (T1), le condensateur (C1) étant chargé selon une fonction-e tant qu'existe sur la ligne de commande (37) un niveau haut à la base d'un transistor (T1), et le condensateur (C1) pouvant se décharger par l'intermédiaire des bobines primaires (6/1), lorsque la ligne de commande (37) adopte un niveau bas , la raideur de pente de l'impulsion de courant (28) étant déterminée par la hauteur de la tension (U_{E}) au niveau de l'émetteur, et pouvant être commandée par la modification réglable par le micro-ordinateur (24) du temps inactif (t1 à tn) sur la ligne de commande (37).

9. Dispositif de commande selon la revendication 2, caractérisé en ce qu'un générateur d'impulsions (25) est prévu pour un réglage automatique du point de déclenchement, lequel générateur est composé d'une résistance (R1) et d'un condensateur (C1), connecté à sept commutateurs de courant (26), de telle sorte que les sept commutateurs de courant (26) sont inactifs sur les sept lignes de commande (35) au-dessus d'un niveau haut , pour charger le condensateur (C1) par l'intermédiaire de la résistance (R1), et de telle sorte qu'un commutateur de courant (26) devient conducteur à un niveau bas sur une ligne de commande (35), que le temps inactif (t1 à tn) se termine, et qu'une impulsion de courant (28) passe par l'intermédiaire d'un transistor (T5) jusqu'à ce que le condensateur (C1) soit déchargé.

10. Dispositif de commande selon la revendication 9, caractérisé en ce que la raideur de pente d'une impulsion de courant (28) est commandée de façon variable par un micro-ordinateur (24), la valeur du temps inactif (t1 à tn) pouvant être modifiée par ce dernier (24) pour chacune des touches (1), et une valeur de temps inactif (t1 à tn) pouvant ainsi être associée à chacune des touches.

11. Dispositif de commande selon la revendication 10, caractérisé en ce qu'un temps inactif (t1 à tn) déterminé une fois pour toutes et associé à chacune des touches (1) est consigné sous forme de valeur non modifiable sur un tableau de valeurs.

12. Dispositif de commande selon la revendication 10, caractérisé en ce qu'une valeur du temps inactif est prévue pour chacune des touches (1), laquelle valeur est consignée sous forme de valeur pouvant être modifiée dans une mémoire à lecture-écriture du micro-ordinateur (24).

13. Dispositif de commande selon la revendication 1, caractérisé en ce qu'est prévu un amplificateur de lecture (32) dont la sensibilité peut être commandée par le micro-ordinateur (24) par l'intermédiaire d'une ligne de commande (33), de façon à ce qu'un passage de l'état haut à l'état bas sur la ligne de commande (33) assure un déclenchement anticipé, pouvant varier de 2 mm, d'un signal de touche au niveau de la sortie (40), de telle sorte qu'une touche (1) capable de fonctionner fournit un signal de touche qui atteint la hauteur d'un signal de couplage de base (39) pour commuter l'amplificateur de lecture (32) sur une impulsion bas au niveau de la sortie (40).

14. Dispositif de commande selon la revendication 1, caractérisé en ce qu'un flip-flop (41) est prévu du côté sortie de l'amplificateur de lecture (32), pour conserver un signal de touche existant jusqu'à ce qu'intervienne un appel d'un signal de touche par le micro-ordinateur (24) par l'intermédiaire des lignes de commande (42, 43).
